# EUROPÄISCHE PATENTSCHRIFT

(11) **EP 0 513 518 B1**
(45) Veröffentlichungstag und Bekanntmachung des Hinweises auf die Patenterteilung: **02.08.1995**
(21) Anmeldenummer: 92105865.7
(22) Anmeldetag: 04.04.1992
(51) Int. Cl.: C23C 16/26

(54) **Verfahren zur Herstellung von synthetischen Diamantschichten auf Substraten**
Process for depositing synthetic diamond coatings on substrates
Procédé d'obtention de couches de diamant synthétique sur des substrats

(30) Priorität: 16.05.1991 DE 4115930
(43) Veröffentlichungstag der Anmeldung: 19.11.1992
(73) Patentinhaber: UTP Schweissmaterial GmbH & Co. KG, D-79189 Bad Krozingen (DE)
(72) Erfinder: Hühne, Erwin Dieter, W-7801 Schallstadt (DE)
(74) Vertreter: Ratzel, Gerhard, Dr.

(56) Entgegenhaltungen:
- EP-A- 0 491 521
- CHEMICAL ABSTRACTS, vol. 114, no. 20, 20. Mai 1991, Columbus, Ohio, US; abstract no. 188386E, G.V. SAKOVICH ET AL: 'production of diamond clusters by explosion and their effective use' Seite 163; Spalte 2
- CHEMICAL ABSTRACTS, vol. 114, no. 6, 11. Februar 1991, Columbus, Ohio, US; abstract no. 48223Z, V.S. KLIMENKO: 'characteristics of formation of detonation-produced diamond-containing coatings' Seite 327; Spalte 2
- Database WPIL, Derwent Publication Ltd, London, GB, Abstract no 88-101246
- Database WPIL, Derwent Publication Ltd, London, GB, Abstract no 88-273963
- Römpps Chemie-Lexikon, Band 1, 8. Auflage, 1979, Seite 280

## Beschreibung

Aufgrund der speziellen Materialeigenschaften von Diamanten, insbesondere der hohen Härte, wird ein hoher Prozentsatz der geförderten Naturrohdiamanten in technischen Bereichen verwendet, wie z.B. für Werkzeuge zum Bearbeiten von Werkstoffen mit hoher Härte durch Schleifen, Bohren oder Schneiden. Die große Nachfrage nach Diamanten für technische Zwecke, hat zur Entwicklung von verschiedenen Verfahren zur Herstellung von Industriediamanten und zum Aufbringen synthetischer, dünner Diamantschichten auf Substraten geführt. Die synthetisch hergestellten Diamantschichten dienen vorwiegend der Vergütung von Werkzeugen der Feinmechanik und der Mikrotechnologie. Dünne Diamantschichten lassen sich mit Hilfe des CVD-Verfahrens (CVD = Chemical Vapour Deposition) oder mittels plasmagestützter Prozesse erzeugen. Diese Verfahrenstechnik ermöglicht die Herstellung von synthetischen Diamantschichten bei niedrigen Drücken von ca. 1,33 bis 13300 Pa (ca. 0,01 bis 100 torr) und bei moderaten Substrattemperaturen von ca. 800 °C bis 1000 °C.

Die EP-A-0 491 521 ist ein Dokument, das unter Artikel 54(3) EPÜ fällt. Die EP-A-0 491 521 offenbart das Beschichten von Substraten bei Substrattemperaturen von 500-1200°C mit Diamantschichten ausgehend von reduzierenden kohlenstoffhaltigen Gemischen von Acetylen, Propan oder Propen (allgemein Kohlenwasserstoff) mit Sauerstoff bevorzugt in einer Vakuumkammer unter reduziertem Druck oder unter Inertgasatmosphäre mittels einer Hochgeschwindigkeitsflamme, die mit einem zum Substrat beweglichen Hochgeschwindigkeitsbrennersystem erzeugt wird und deren Abstand zum Substrat damit eingestellt werden kann bzw. über das Substrat bewegt wird.

In der europäischen Patentanmeldung 0 413 394 wird ein Verfahren zur Herstellung von polykristallinen Diamantschichten beschrieben, bei dem Diamantkristallite bei einem Druck im Bereich von 10⁻⁵ bis 1 bar aus einer Gasphase, die Wasserstoff und bis zu 30 % eines kohlenstoffhaltigen Gases enthält, mittels CVD auf einem auf eine Temperatur im Bereich von 450 bis 1200°C aufgeheizten Substrat abgeschieden werden. Das Substrat wird dazu mit einer Gasphase in Kontakt gebracht, deren Energieinhalt zeitlich variiert.

Zumindest zu Beginn des Abscheidungsprozesses muß der Energieinhalt der Gasphase zur Nukleation von Diamantkristalliten geeignet sein, um die Substratoberfläche mit Diamantkristalliten zu bekeimen. Um weitere Diamantkritallite in situ auf der bekannten Substratoberfläche zu bilden, muß das Substrat mit einer Gasphase in Kontakt gebracht werden, deren Energieinhalt gegenüber dem Anfangszustand erhöht ist.

In "COMBUSTION SYNTHESIS OF DIAMOND", W.A. Yarbrough, et al, Surface and Coatings Technologie, 39/40 (1989) Seiten 241-252, wird die Verwendung eines unveränderten Sauerstoff-Acetylenlöt/Schweißbrenners zur Erzeugung von Diamantschichten vorgeschlagen. Wegen der hohen Temperatur des Gases wird das Substrat bzw. der Substrathalter Wasser gekühlt.
Der Brenner wird bei einem Druck von 3333 bis 6665 Pa (25 bis 50 torr) betrieben und mit einem Verhältnis Sauerstoff zu Acetylen von ungefähr 1,16.

In der europäischen Patentanmeldung 0 379 994 wird ein Verfahren zur Abscheidung polykristalliner Diamantschichten auf einem kühlbarem Substrat beschrieben, bei dem ein C₂H₂-O₂ Unterschuß eingesetzt wird. Aufbau des Brenners und Brenngeschwindigkeit werden in dieser Schrift nicht spezifiziert.

In der europäischen Patentanmeldung 0 324 538 wird ein Verfahren zur Abscheidung von polykristallinen Diamant durch unvollständige Verbrennung in einer C₂H₂-O₂-Flamme beschrieben. Auch hier werden weder der Brenneraufbau noch die Brenngeschwindigkeit spezifiziert.

In diesen Schriften wird immer die Verwendung von offenen Acetylen-Sauerstoff-Flammen konventioneller Autogenbrenner zur Abscheidung von synthetischen Diamantschichten beschrieben.

In dem US-Patent 2,714,563 wird eine Detonationskanone und deren Wirkungsweise beschrieben. Eine einzelne Brennstoffladung oder eine schnelle Folge von Brennstoffladungen, deren Zusammensetzung eine Detonation ermöglicht, wird einer Kanone zugeführt und dort entzündet, um eine einzelne Detonation oder eine Folge von Detonationen in kurzen Zeitabständen zu realisieren. In diese Kanone werden Partikel wie Pulver in geeigneter Weise eingeführt, so daß sie durch die Detonation und die damit verbundenen Phänomene beschleunigt und von dem offenen Ende der Kanone auf eine Oberfläche projeziert werden. Ein Gerät, mit dem man das vorgehend beschriebene Verfahren durchführen kann, wird gemein hin als Detonationskanone bezeichnet.

Der Erfindung liegt die Aufgabe zugrunde, ein Verfahren zur Verfügung zu stellen, mit dem schnell und mit geringem Aufwand, insbesondere mit geringem apparativem Aufwand, synthetische Diamantschichten auf Substraten erzeugt werden können. Mit den erfindungsgemäßen Verfahren soll schließlich auch eine Kostenreduzierung bei der Herstellung von synthetischen Diamantschichten erzielt werden.

Bei dem erfindungsgemäßen Verfahren wird das zu beschichtende Substrat direkt in der gekühlten, vorzugsweise wassergekühlten Detonationskammer eines Hochgeschwindigkeits-Brennersystems angeordnet. Bei dem Substrat kann es sich um einen metallischen Träger oder um einen Metalloidträger, wie z.B. einen Siliciumwafer handeln.

Als Substratmaterial kommen aber beispielsweise auch Metalloxide, mineralische Materialien oder eine Keramik in Frage. Je nach Applikation kann das Substrat entweder fest fixiert oder bewegbar angeordnet sein. Die Detonationskammer wird mit geeigneten Schutzgasen gefüllt, d.h. es wird zunächst eine die Oxidation des Substrats verhindernde Atmosphäre erzeugt. Das Substrat wird auf eine vorgewählte Prozeßtemperatur aufgeheizt und möglichst konstant auf dieser Temperatur gehalten. Dies kann beispielsweise durch elektrische Widerstands- oder Induktiverwärmung erfolgen. Die Atmosphäre in der Detonationskammer verhindert die Oxidation der zu beschichteten Fläche während des Erhitzens des Substrats.

Die Detonationskammer besitzt einen oder mehrere Einlaßventile für die Betriebsgase und Auslaßventile für die Abgase, die in Entladungskanälen münden. Die Ein- und Auslaßventile werden in Anpassung an den Verfahrensablauf, insbesondere die Detonationsfrequenz über eine Nockenwelle betätigt. Dieser Detonationskammer vorgeschaltet ist eine Gasmischkammer, die ebenfalls eine oder mehrere Nockenwellen zur Steuerung der Ein- und Auslaßventile für die Betriebsgase besitzt, die prozeßsynchron zu den Ein- und Auslaßventilen der Detonationskammer geöffnet oder geschlossen werden. Das eigentliche Beschichten der präparierten erhitzten Substratoberflächen verläuft wie folgt:
Über die geöffneten Einlaßventile werden ein oder mehrere Kohlenwasserstoffgase, wie z.B. Acetylen oder Propangas, und Sauerstoff entweder vorgemischt oder getrennt vorgemischt in die Gasmischkammer eingepreßt. Im Falle von Acetylen und Sauerstoff kann das Mischungsverhältnis zwischen 1 : 1 bis ca. 2 : 1 liegen, bei Verwendung von Propangas-Sauerstoff-Gemischen variiert das Mischungsverhältnis von 1 : 2 bis 1 : 4,35. In diesem Stadium sind die Einlaßventile zwischen Gasmischkammer und Detonationskammer geschlossen, so daß in der Gasmischkammer ein Kammerdruck von z.B. 1,5 bar beim Betrieb mit Acetylen und Sauerstoff und von z.B. 4,5 bar bei der Anwendung eines Propangas-Sauerstoff-Gemischs beträgt. Die Einlaßventile der Gasmischkammern, werden für die Beschickung mit den Betriebsgasen zunächst geschlossen. Im nächsten Verfahrensschritt werden die Auslaßventile der Detonationskammer zu den Entladungskanälen geöffnet. Hierbei entweichen Argon und sonstige Schutzgase über die Entladungskanäle.

Dann werden die Einlaßventile zwischen Gasmischkammer und Detonationskammer geöffnet, so daß das kohlenstoffreiche Detonationsgemisch in die entspannte Detonationskammer einströmen kann und sich hierbei an dem vorgeheizten Substrat entzündet, wobei es explosionsartig verbrennt. Auf der Substratoberfläche lagern sich hierbei Kohlenstoff in Form von Graphit ab, der sich aufgrund der hohen Substrattemperatur und des Detonationsdrucks zu Diamantkristallen umwandelt. Die hoch erhitzten Verbrennungsgase strömen über die Entladungskanäle bei geöffneten Auslaßventilen ab. Nach dieser Operation werden die Einlaßventile zwischen Gasmischkammer und Detonationskammer wieder geschlossen und der Prozeß wiederholt sich wie beschrieben gemäß der vorgewählten Detonationsfrequenz und Prozeßdauer.

Mit dem erfindungsgemäßen Verfahren entsprechend dem Anspruch 7, können mit Hilfe einer Hochgeschwindigkeitskohlenwasserstoff-Sauerstofflamme eines Hochgeschwindigkeitsbrennersystems oder einer Intervalldetonationsflamme, die mit Hilfe einer Detonationskanone erzeugt wird, auch synthetische Diamantschichten auf Substraten außerhalb der Detonationsbrennkammer erzeugt werden. Das zu beschichtende Substrat, wird dazu drehbar beispielsweise in einem nach beiden Seiten offenen Rohr montiert. Dieses Rohr ist als Schutzmantelrohr, für diese Anwendung als Doppelmantel- oder Dreimantelrohr mit Radialkammerkonstruktion, ausgelegt. Ein erster Mantel, bzw. eine erste Kammer dient für das Schutzgas; der zweite Mantel, bzw. die zweite Kammer für das Kühlmedium. Das sich im Zentrum des Schutzrohres befindende dreh- oder achsial verschiebbare Substrat, wird zunächst auf die gewünschte Prozeßtemperatur, von ca. 450 bis 1200°C aufgeheizt, beispielsweise induktiv oder durch elektrische Widerstandserwärmung, während aus dem Innenmantel des Schutzrohres aus achsialen Bohrungen Schutzgas ausströmt. Dieses Schutzgas verhindert die Oxidation der Substratoberfläche während des Erhitzungsprozesses. Nun wird entweder mit einem Hochgeschwindigkeits-Brennersystem, das mit einem Kohlenwasserstoff-Sauerstoff-Gemisch betrieben wird, eine Hochgeschwindigkeitsflamme mit Gasüberschuß erzeugt oder mit einer Detonationskammer eine Intervalldetonationsflamme. Das Substrat wird mit einer definierten Radialumdrehung und einer entsprechenden Achsialverschiebung so bewegt, daß die Hochgeschwindigkeitsflamme oder die Intervalldetonationsflamme unter Einhaltung eines einstellbaren Abstandes zur Substratoberfläche die gesamte zu beschichtende Substratoberfläche überstreicht. Zwischen der Flammenaustrittsöffnung und dem Schutzmantelrohr, wird die Flamme nach außen abgeschirmt und in ein wassergekühltes Mantelrohr geführt.

Aus der kohlenstoffhaltigen Flamme schlägt sich freier Kohlenstoff in Form von Graphit auf der vorgeheizten Substratoberfläche nieder und wandelt sich aufgrund des hohen Flammendrucks auf der flammenbeaufschlagten Substratoberfläche in Diamantkristalle um. Das Substrat wird über die gesamte Dauer des Beschichtungsprozesses auf einer vorgewählten, konstanten Temperatur gehalten. Dies kann beispielsweise mit Hilfe von speziellen Kühldüsen erreicht werden, die mit flüssigem Stickstoff oder flüssigem CO₂ betrieben werden. Zur Prozeßunterstützung kann durch den zentralen Beschickungskanal im Düsensystem des Hochgeschwindigkeisbrenners oder der Detonationskanone Kohlendioxid (CO₂) zugeführt werden.

Zur Erzeugung von Diamantschichten auf großen Substratflächen ist es vorteilhaft, in einer mit Schutzgas gefüllten Kammer zu arbeiten, in der das Substrat beispielsweise induktiv oder durch elektrische Widerstandserwärmungen auf die entsprechende Prozeßtemperatur von ca. 450 bis 1200°C vorgeheizt wird. In der Schutzgaskammer befindet sich entweder ein Hochgeschwindigkeitsbrennersystem oder eine Detonationskanone, die jeweils mit einem KohlenwasserstoffSauerstoff-Gasgemisch betrieben werden. Mit einer Detonationskanone können Intervalldetonationsflammen erzeugt werden, im Gegensatz zu kontinuierlich brennenden Hochgeschwindigkeitsflammen, bei Verwendung eines Hochgeschwindigkeitsbrenners. In beiden Fällen werden als Betriebsgase vorwiegend Acetylen, Propangas und Sauerstoff verwendet.

Die Mischungsverhältnisse zwischen den verwendeten Kohlenwasserstoffgasen und dem Sauerstoff, werden dabei so eingestellt, daß eine reduzierende Gasüberschlußflamme entsteht, z.B. bei Verwendung von Acetylen und Sauerstoff als Betriebsgas ein Mischungsverhältnis von 1:1 bis 1,8. Die kohlenstoffhaltige Interevalldetonationsflamme, bzw. die kontinuierlich brennende Hochgeschwindigkeitsflamme, wird wieder mit einer definierten Geschwindigkeit und einem einstellbaren Abstand über die Substratoberfläche geführt. In dem Beaufschlagungsbereich der kohlenstoffhaltigen Flamme lagert sich Kohlenstoff auf dem, auf möglichst konstanter Temperatur gehaltenen Substrat ab, der sich unter dem hohen Flammendruck in Diamantkristalle umwandelt. Dieser Prozeß kann durch Zusätze von sehr fein pulverisiertem Graphit, der in Verbindung mit einem geeigneten Trägergas in die Flamme eingebracht wird, unterstützt werden.

Bei den erfindungsgemäßen Verfahren wird anstelle eines konventionellen Autogenbrenners, die bei den Verfahren entsprechend dem Stand der Technik verwendet werden, ein Hochgeschwindigkeitsbrenner oder eine Detonationskanone verwendet. Der Flammen- bzw. Detonationsdruck auf der erhitzten Substratoberfläche, ist um das 20 bis 100fache höher, als bei den vorbekannten Technologien. Dadurch kommt es zu einer wesentlich schnelleren Diamantkristallisation, wie bei den Verfahren nach dem Stand der Technik-. Es können also bei gleicher Prozeßdauer dickere, synthetische Diamantschichten erzeugt werden, bzw. kann mit der erfindungsgemäßen Technologie die Prozeßdauer um 1000 bis 2000 %, gegenüber Verfahren, nach dem Stand der Technik, reduziert werden.

Die erfindungsgemäße Verfahren können vorteilhaft mit den im Folgenden aufgelisteten, brennbaren Kohlenwasserstoffgasen und den unbrennbaren Schutzgasen durchgeführt werden:

### Brennbare Kohlenwasserstoffgase

1. Acetylen - C₂H₂
2. 1,3-Butadien 2,5 - C₄H₆
3. Butan 2,5 (N-Butan) - C₄H₁₀
4. I-Buten 2,3 - C₄H₈
5. cis-2-Buten - C₄H₈
6. trans-2-Buten - C₄H₈
7. 1,1-Difluorethan R 152a - C₂H₄F₂
8. Dimethylamin - C₂H₇N
9. 2,2-Dimethylpropan - C₅H₁₂
10. Ethan - C₂H₆
11. Ethen - C₂H₄
12. Isobutan - C₄H₁₀
13. Isobuten - C₄H₈
14. Methan - CH₄
15. Methylvinylether - CH₃-O-CH = CH₂
16. Propan - C₃H₈
17. Propen - C₃H₆

### Unbrennbare Schutzgase

1. Argon - AR
2. Helium - He
3. Helium-3 He
4. Hexafluorethan R 116 - C₂F₆
5. Kohlendioxid - CO₂
6. Krypton - Kr
7. Neon - Ne
8. Xenon - Xe

Ausführungsbeispiele der Erfindung sind in der Zeichnung dargestellt und in der nachfolgenden Beschreibung näher erläutert.

Es zeigen:
- Die Figur 1: die Schnittdarstellung eines Hochgeschwindigkeitsbrennersystems mit Detonationsbrennkammer und
- Figur 2: die Schnittdarstellung eines weiteres Hochgeschwindigkeitsbrennersystems mit Detonationsbrennkammer.

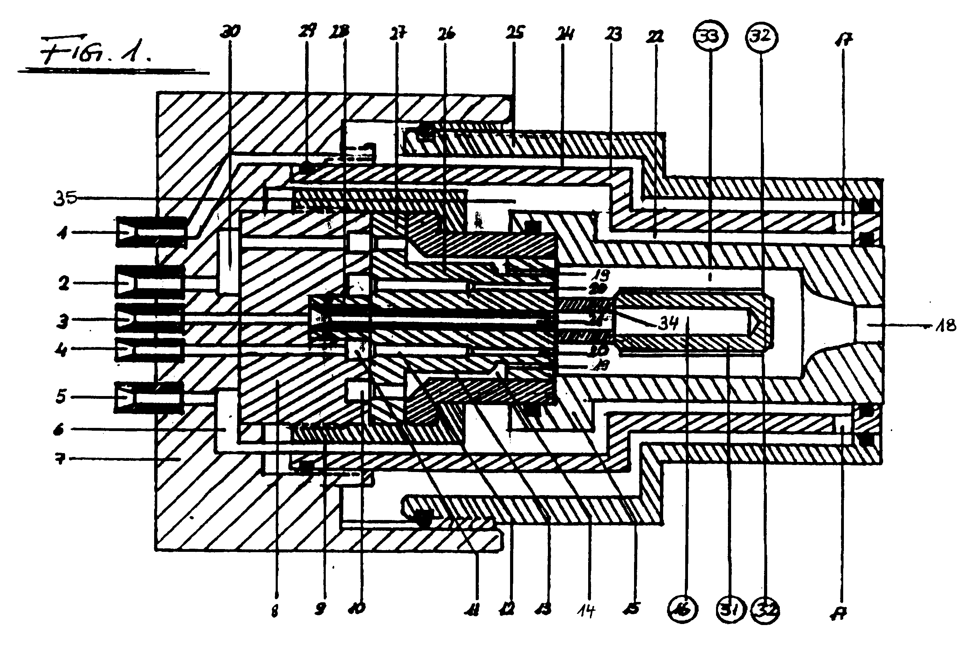

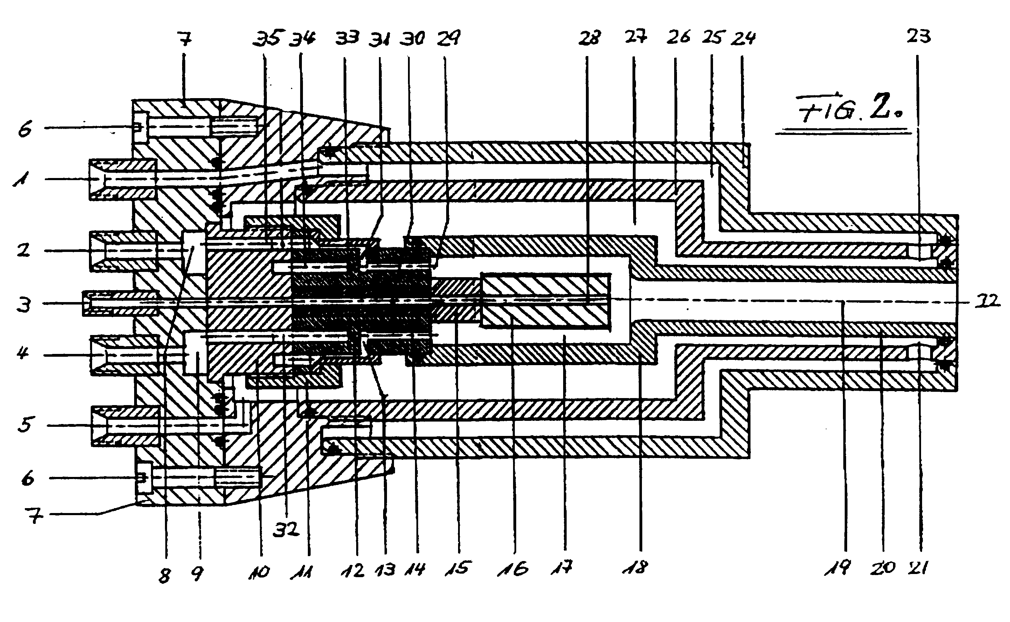

Die in den Figuren 1 und 2 dargestellten Hochgeschwindigkeitsbrennersysteme weisen jeweils eine zylindrische Detonationsbrennkammer 33; 17 auf, die an einer Stirnseite eine als Entladungskanal dienende Austrittsbohrung 19; 22 aufweist.
An der anderen Stirnseite grenzt ein Gasmischblock 26 in Verbindung mit einem Gasmischblockträger 8;10 an die Detonationsbrennkammer 33;17. Diese Strukturelemente werden von einem Gehäuse 15;18,24,26 ummantelt, das zumindest Teile eines Kühlwasserkreislaufs beinhaltet.

In dem zylindrischen Detonationsbrennkammerraum 33 des in Figur 1 dargestellten Ausführungsbeispiels, wird zunächst ein mit einem zylindrischen Kühlmedium-Hohlraum 16 versehener Substratträger 31 für ein Substrat 32 so fixiert, daß sich zwischen dem Gasmischblock 26 und dem Substratträger 31 eine Isolationshülse 34 befindet, die stirnseitig zum Gasmischblock 26 angeordnet ist. Über einen Anschluß wird eine Temperaturmeßsonde durch eine Bohrung 21, die den Gasmischblock 26 durchdringt und in die Isolationshülse 34 mündet, an die sich wiederum der zylindrische Hohlraum 26 des Substratträgers 31 anschließt, in die Brennkammerinnenwandung des Substratträgers 31 integriert.

Die Temperaturmeßsonde ist mit einer Meß-Auswerte- und Regelelektronik verknüpft. Über den Anschluß 3 und die Bohrung 21 werden außerdem während der Prozeßdauer Kühlmittel in den zylindrischen Hohlraum 16 des Substratträgers 31 zu- und abgeführt. Dadurch kann die Temperatur des Substrats 32 auf einem vorgewählten Wert konstant gehalten werden.

An einem Anschluß 1 wird der Apparatur Kühlmittel zugeführt, das über einen Kühlwasserringraum 27 und über eine Vielzahl von Kühlwasserradialbohrungen 17 auf die Außenwandung des Detonationsbrennkammergehäuses 15, mit der Expansionsdüsenbohrung 18 gelangt und die gesamte Detonationsbrennkammer von außen kühlt, in dem es durch Ringräume 22 und 35 zurückströmt. Über einen Anschluß 5 gelangt das während des Prozeßablaufs erhitzte Kühlwasser zu einen Kühlblocksystem, wo es auf eine Temperatur von ca. 16 bis 18°C zurückgekühlt wird. Vom Kühlblock gelangt das Kühlwasser in einem Kreislauf wieder zum Anschluß 1.

An einem Anschluß 2 wird der Apparatur zunächst reiner Wasserstoff oder ein Wasserstoff-Sauerstoff-Gemisch zugeführt. Über eine radiale Druckausgleichkammer 30 gelangt der Wasserstoff oder das Gemisch über eine Vielzahl von radial-achsial-Bohrungen in eine Ringnut 10 eines Gasmischblockträgers 8, auf dem der Gasmischblock 26 angeordnet ist. In der Ringnut erfolgt ein Druckausgleich durch radiale Verteilung des Gases. Durch eine Vielzahl von Achsialbohrungen, die von der Ringnut 10 ausgehen, strömt der Wasserstoff oder das Gemisch durch einen Ringraum 13 in eine Radialnut 14, um fein verteilt über eine Vielzahl von Achsialbohrungen 19 in den Detonationsbrennkammerraum 33 zu gelangen und aus der Expansionsdüse 18 auszutreten.

Die Betriebsgasmenge wird beim Start des Prozesses so ausgelegt, daß der Volumenstrom des Wasserstoffs oder Wasserstoff-Sauerstoff-Gemisches so gering ist, daß bei der Zündung des aus der Expansionsdüse 18 austretenden Gases die Flamme in den Detonationsbrennkammerraum 33 zurückschlägt. Die Wasserstoff- bzw. Wasserstoff-Sauerstoff-Flamme überstreicht hierbei die gesamte Oberfläche des Substrats 32, wobei dieses aufgeheizt wird. In diesem Zustand wird die Menge der Wasserstoff- bzw. der Wasserstoff-SauerstoffGemischzuführung durch Druckerhöhung erheblich vergrößert, so daß sich der Brennkammerdruck entsprechend erhöht. Dabei entsteht eine H₂ - oder H₂ + O₂ -Hochgeschwindigkeitsflamme, die das Substrat auf eine vorgewählte Prozeßtemperatur von ca. 450 bis 1000°C erhitzt und gleichzeitig vor Oxidation schützt. Die Prozeßtemperatur wird durch entsprechende Steuerung der zugeführten Kühlmittelmengen in das Innere des Substratträgers 31, sowie durch entsprechende Steuerung der Betriebsgase konstant gehalten.

Sobald die erforderliche Substrattemperatur erreicht ist, wird über einen Anschluß 4 ein Kohlenwasserstoff-Sauerstoff-Gemisch, vorzugsweise Acetylen (C₂ H₂) und Sauerstoff (O₂), im Mischungsverhältnis 1 : 1 bis etwa 2 : 1 zugeführt. Bei Verwendung von anderen Kohlenwasserstoff-Sauerstoff-Gemischen werden die Mischungsverhältnisse so gewählt, daß eine kohlenstoffhaltige Flammenatmosphäre entsteht. Das Kohlenwasserstoff-Gemisch (C₂H₂ + O₂) gelangt in eine Radialnut 11, die als Druckausgleichskammer und Mischorgan für die Betriebsgase dient.

Von dort aus strömt das Brenngas-Sauerstoff-Gemisch durch ein Vielzahl von Achsialbohrungen 12, die stirnseitig, radialkonzentrisch um das Substrat 32 angeordnet sind, aus und entzündet sich. In dieser Phase des Prozeßablaufs wird die Zuführung von Wasserstoff oder des Wasserstoff-Sauerstoff-Gemischs am Anschluß 2 unterbrochen, so daß in dem Detonationsbrennkammerraum 33 eine mit Kohlenstoff angereicherte C₂H₂ + O₂-Hochgeschwindigkeitsflamme brennt und dabei einen hohen Detonationsbrennkammerdruck erzeugt. Dabei lagert sich auf der Oberfläche des Substrats 32 eine Graphitphase ab, die sich aufgrund des hohen Brennkammerdrucks und der vorgewählten Substrattemperatur in Diamantkristalle umwandelt. Das erfindungsgemäße Verfahren wird in einem Intervallzyklus so gesteuert, daß abwechselnd einmal eine Wasserstoff- bzw. Wasserstoff-Sauerstoff-Hochgeschwindigkeitsflamme und einmal eine Acetylen-Sauerstoff-Hochgeschwindigkeitsflamme entsteht. Durch die Wasserstoff- bzw. Wasserstoff-Sauerstoff-Hochgeschwindigkeitsflamme wird die Ablagerung von Graphit unterdrückt und das Wachstum von Diamantkristallen begünstigt. Die Randkristalle vermehren sich und wachsen in Abhängigkeit von der Prozeßdauer und der Substrattemperatur.

Das vorangegangene beschriebene Verfahren kann wie folgt variiert werden:
Die Zuführung der Betriebsgase, Acetylen + Sauerstoff und Wasserstoff bzw. Wasserstoff + Sauerstoff in den vorgewählten Mischungsverhältnissen erfolgt 4 bis 20 mal/sec alternierend in Zyklen, in denen die Absperrventile der Gaszuführungen motorisch geöffnet und geschlossen werden.

Das Acetylen-Sauerstoff-Gemisch oder der Wasserstoff bzw. das Wasserstoff-Sauerstoff-Gemisch strömt in den vorgenannten Intervallen in die Detonationsbrennkammer ein. Bei den Unterbrechungszyklen der Betriebsgaszuführung erlischt die Flamme jeweils. Beim erneuten öffnen der Gasventile entzündet sich das Brenngas-Sauerstoff-Gemisch explosionsartig, wobei es durch den hohen Explosionsdruck zum Acetylenzerfall in C₂ und H₂ kommt. Der hierbei entstehende Kohlenstoff bzw. die entstehende Graphitphase schlägt sich unter anderem auf der Substratoberfläche nieder und wandelt sich aufgrund des hohen Brennkammerdrucks (Explosionsdruck) und der Substrattemperatur in Diamantkristalle um. Zum Unterschied zu der zuerst geschilderten Prozeßtechnologie entsteht durch das öffnen und Schließen der Gasventile im Abstand von Intervallen in der Detonationsbrennkammer eine Intervalldetonationsflamme mit einer Frequenz von 4 Detonationen pro Sekunde, was zu einem höheren Detonationsdruck in der Brennkammer führt. Die Anzahl der hierbei entstehenden Diamantkristalle sowie deren Größe und Dichte, werden durch die Dauer des Prozesses beeinfluß, was sich auch auf die Schichtstärke auswirkt.

In Figur 2 ist mit 16 ein Substratträger bezeichnet, der beispielsweise als Zylinder aus Molybdän ausgebildet sein kann. Er ist in der Detonationskammer 17 so angeordnet, daß zwischen dem Gasmischblock und dem Substratträger 16 eine Isolationshülse 15 eingebaut ist. Über einen Anschluß 1 wird Kühlwasser zugeführt, das durch einen Ringraum 25, der zwischen einer Außenschraubhülse 28 und einen Innenschraubhülse 26 angeordnet ist, und über Radialbohrungen 21 und 23 in den Kühlwasserringraum 27 gelangt. Über einen Anschluß 5 strömt das Kühlwasser ab und wird in einem Wärmeaustauscher auf eine Temperatur von ca. 18 bis 20°C abgekühlt und mittels einer Kühlwasserpumpe über ein Leitungsystem wieder am Anschluß 1 zugeführt.

Über einen Anschluß 2 wird der Apparatur zunächst Wasserstoff zugeführt, der über eine Radialdruckausgleichskammer 8 und über eine Vielzahl von Achsialbohrungen 35 im Gasmischblockträger 10 in einen Injektorringspalt 13/31 gelangt. Über einen Anschluß 4 wird Sauerstoff zugeführt, der über eine Radialdruckausgleichskammer 9 und über eine Vielzahl von Achsialbohrungen 32 im Gasmischblockträger 10, mit hohem Druck, durch Injektordruckdüsenbohrungen 12 den mit Wasserstoff gefüllten Injektorspalt 13/31 mit Überschallgeschwindigkeit durchströmt. Die hochbeschleunigten Sauerstoffströme münden in jeweils gegenüberliegende Injektormischdüsenbohrungen 29 und reißen dabei Wasserstoff aus dem Injektorringspalt 13/31 mit. Das Wasserstoff-Sauerstoff-Gemisch strömt dann in den Detonationsbrennkammerraum 17. Durch die Expansionsdüsenbohrung 19 tritt das Gemisch an der Stirnseite der Detonationsbrennkammer aus, wo es elektrisch gezündet wird.

Aufgrund der relativ geringen Strömungsgeschwindigkeit des Wasserstoff-Sauerstoff-Gemisches schlägt die Flamme in die Detonationsbrennkammer 17 zurück, wo sie weiterbrennt. Das im Innern der Detonationsbrennkammer fixierte Substrat wird dabei erhitzt und gleichzeitig durch die reduzierend brennende H₂ + O₂ -Flamme vor Oxidation geschützt. Der Substratträger ist mittels eines Anschlusses 3 mit einer Temperaturmeßsonde verknüpft.

Darüber hinaus wird durch den Anschluß 3 und über eine Zentralbohrung 28, die den Gasmischblockträger 10 in Verbindung mit dem Gasmischblock durchdringt und in die Isolationshülse 15 mündet, ein Kühlgas in das Innere des Substratträgers geleitet, das so geregelt ist, daß die Substrattemperatur auf einem vorgewählten Wert konstant gehalten wird, z.B. bei 800°C. Sobald die Temperatur von 800°C erreicht ist, wird am Anschluß 2 ein Kohlenwasserstoffgas, z.B. C₂H₂, gleichzeitig mit H₂ zugeführt und der Zustromdruck des O₂ am Anschluß 4 erheblich erhöht. In der Detonationsbrennkammer 17 brennt nun bei hohem Brennkammerdruck eine Flamme aus einem H₂ + C₂H₂ + O₂ -Gemisch, die mit sehr hoher Geschwindigkeit aus der Expansionsdüsenbohrung 19 stirnseitig austritt. In diesem Stadium des Verfahrens wird die Wasserstoffzuführung abgestellt, so daß in der Detonationsbrennkammer 17 eine kohlenstoffreiche C₂H₂ + O₂ - Flamme brennt, aus der sich Kohlenstoff in Form von Graphit auf dem erhitzten Substrat ablagert und in Folge des hohen Detonationsbrennkammerdrucks in Diamantkristalle umwandelt. In einem Intervallzyklus wird abwechselnd die C₂H₂-Zuführung unterbrochen und Wasserstoff zugeführt, der die Graphitphase während der Diamantkritallbildung unterdrückt.

Die C₂H₂ + H₂-Zuführung kann so geregelt werden, daß anstelle einer kontinuierlich brennenden Hochgeschwindigkeitsflamme eine Intervalldetonation in der Detonationsbrennkammer eingeleitet wird. Durch die hierbei enstehenden hohen Drücke in der Detonationbrennkammer 17, wird die Diamantkristallbildung begünstigt.

### Bezugszeichenliste zu Figur 1

- 1: Anschluß für Kühlwasser "Eingang"
- 2: Anschluß für Wasserstoff und/oder Wasserstoff-Sauerstoff-Gemisch
- 3: Anschluß für Kühlmittel - Zugang und Abgang zum Substratträger und Temperaturmeßsonde
- 4: Anschluß für Kohlenwasserstoffgas - Sauerstoff-Gemisch (z.B. C₂H₄ + O₂ oder C₃H₆ + O₂)
- 5: Anschluß für Kühlwasser "Ausgang"
- 6: Kühlwasserraum - Rücklauf
- 7: Geräteanschlußblock für die Betriebskomponenten
- 8: Gasmischblockträger
- 9: Preßschraube für Gasmischblock
- 10: Radialringnute und Druckausgleichsraum für Wasserstoff- oder Wasserstoff-Sauerstoff-Gemisch
- 11: Radialringnute und Druckausgleichsraum für Kohlenwasserstoff-Sauerstoff-Gemisch
- 12: Axialbohrungen für Kohlenwasserstoff-Sauerstoff-Gemisch
- 13: Ringraum für Wasserstoff- und Wasserstoff-Sauerstoff-Gemisch
- 14: Radialringnute
- 15: Detonations-Brennkammergehäuse
- 16: Kühlmedium-Hohlraum (im Substratträger)
- 17: Kühlwasser-Radialbohrungen
- 18: Entladungskanalbohrung (Expansionsdüsenbohrung)
- 19: Austrittsbohrungen für Wasserstoff oder Wasserstoff-Sauerstoff-Gemisch
- 20: Austrittsbohrungen für Kohlenwasserstoff-Sauerstoff-Gemisch
- 21: Kühlmittelbohrung in dem Isolator (34)
- 22: Kühlwasser-Ringraum (Rücklauf)
- 23: Zwischenschraubhülse
- 24: Kühlwasser-Ringraum (Vorlauf)
- 25: Außenschraubhülse
- 26: Gasmischblock
- 27: Innenblock
- 28: Verschleißschutzhülse
- 29: Dichtelement
- 30: Radial-Druckausgleichskammer
- 31: Substratträger
- 32: Substrat
- 33: Detonationsbrennkammer-Raum
- 34: Isolationshülse (Temperatur-Isolation)
- 35: Ringraum (Rücklauf)

### Bezugszeichenliste zu Figur 2

- 1: Anschluß für Kühlwasser "Eingang"
- 2: Anschluß für Wasserstoff und Kohlenstoffgase wie z.B. C₂H₂ und C₄H₆
- 3: Anschluß für Substratkühlmittel - Zugang und Anschluß für eine Thermosonde zum Substrat
- 4: Anschluß für Hilfsverbrennungsgas (O₂)
- 5: Anschluß für Kühlwasser "Ausgang"
- 6: Zylinderkopfschraube(n)
- 7: Geräteanschlußblock für die Betriebskomponenten
- 8: Radiale Druckausgleichskammer für Wasserstoff und Kohlenwasserstoffe
- 9: Radiale Druckausgleichskammer für das Hilfsverbrennungsgas (O₂)
- 10: Gasmischblockträger
- 11: Gasmischblock-Preßschraube
- 12: Injektordruckdüsenbohrungen (20x)
- 13: Injektor-Ringspalt (31)
- 14: Verschleißschutzhülse
- 15: Isolationshülse
- 16: Substratträger mit Substrat
- 17: Detonationsbrennkammer
- 18: Detonationsbrennkammergehäuse mit Entladungskanal (20) (Expansionsdüse)
- 19: Entladungskanalbohrung
- 20: Entladungskanalwandung
- 21: (23) Radial-Kühlwasserbohrungen
- 22: Austrittsbohrung-Entladungskanal
- 23: (20) Radial-Kühlwasserbohrung
- 24: Außenschraubhülse
- 25: Kühlwasser-Ringraum
- 26: Innenschraubhülse
- 27: Radial-Kühlwasser-Ringraum
- 28: Kühlmedium-Bohrung (Substratträger)
- 29: Injektor-Mischdüsenbohrungen (20x)
- 30: Beschickungsbohrung für Kühlmittel zum Substratträger und für Temperaturmeßsonde
- 31: Injektor-Ringspalt (13)
- 32: Axialbohrungen für Sauerstoff (Hilfsverbrennungsgas) (34)
- 33: Außen-Gasmischblockmantel
- 34: Axialbohrungen für Sauerstoff-Hilfsverbrennungsgas (32)
- 35: Axialbohrungen für Wasserstoff und Kohlenwasserstoffgas

## Patentansprüche (Patentansprüche für folgende(n) Vertragsstaat(en): AT, BE, CH, DK, ES, GR, IT, LI, LU, MC, NL, PT, SE)

1. Verfahren zur Herstellung von polykristallinen Diamantschichten, bei dem aus einem kohlenstoffhaltigen Gasgemisch Kohlenstoff auf ein auf eine vorgewählte Temperatur aufgeheiztes Substrat abgeschieden wird,
dadurch gekennzeichnet,
daß
(a) das Substrat im Inneren einer kühlbaren Brennkammer eines Hochgeschwindigkeitsbrennersystems angebracht wird,
(b) in der Brennkammer durch Einleiten von oxidationsverhindernden Gasen eine Atmosphäre hergestellt wird, die die Oxidation des Substrats verhindert,
(c) das Substrat in dieser oxidationsverhindernden Atmosphäre auf eine vorgewählte Temperatur zwischen ca. 450 und 1200 °C aufgeheizt wird, so daß sich eine Mischung von Sauerstoff und Kohlenwasserstoffgasen am Substrat selbsttätig entzünden kann,
(d) die oxidationsverhindernde Atmosphäre durch Einleiten der genannten Mischung von Sauerstoff und Kohlenwasserstoffgasen in die Brennkammer gegen ein brennbares, kohlenstoffhaltiges Gasgemisch ausgetauscht wird,
(e) das brennbare, kohlenstoffhaltige Gasgemisch gezündet wird,
wobei die vorgewählte Substrattemperatur während des Prozesses im wesentlichen konstant gehalten wird.

2. Verfahren zur Herstellung von polykristallinen Diamantschichten, bei dem aus einem kohlenstoffhaltigen Gasgemisch Kohlenstoff auf ein, auf eine vorgewählte Temperatur aufgeheiztes, Substrat abgeschieden wird,
dadurch gekennzeichnet,
daß
(a) das Substrat im Inneren einer kühlbaren Brennkammer eines Hochgeschwindigkeitsbrennersystems angebracht wird,
(b) in der Brennkammer durch Einleiten von oxidationsverhindernden Gasen eine Atmosphäre hergestellt wird, die die Oxidation des Substrats verhindert,
(c) das Substrat in dieser oxidationsverhindernden Atmosphäre auf eine vorgewählte Temperatur zwischen ca. 450 und 1200°C aufgeheizt wird, so daß sich eine Mischung von Sauerstoff und Kohlenwasserstoffgasen am Substrat selbsttätig entzünden kann,
(d) die oxidationsverhindernde Atmosphäre durch einleiten der genannten Mischung von Sauerstoff und Kohlenwasserstoffgasen in die Brennkammer gegen ein brennbares, kohlenstoffhaltiges Gasgemisch ausgetauscht wird,
(e) sich das brennbare, kohlenstoffhaltige Gasgemisch selbsttätig am Substrat entzündet,
(f) durch Einleiten von oxidationsverhindernden Gasen wiederum eine Atmosphäre hergestellt wird, die die Oxidation des Substrats verhindert,
(g) die Verfahrensschritte (d) bis (f) für die Dauer des Prozesses mit einer vorgewählten Frequenz in Folge wiederholt werden,
wobei die vorgewählte Substrattemperatur für die Dauer des Prozesses im wesentlichen konstant gehalten wird.

3. Verfahren zur Herstellung von polykristallinen Diamantschichten, bei dem aus einem kohlenstoffhaltigen Gasgemisch Kohlenstoff auf ein, auf eine vorgewählte Temperatur aufgeheiztes, Substrat abgeschieden wird,
dadurch gekennzeichnet,
daß
(a) das Substrat im Inneren einer kühlbaren Detonationsbrennkammer einer Detonationskanone angebracht wird,
(b) in der Detonationsbrennkammer durch Einleiten von oxidationsverhindernden Gasen eine Atmosphäre hergestellt wird, die die Oxidation des Substrats verhindert,
(c) das Substrat in dieser oxidationsverhindernden Atmosphäre auf eine vorgewählte Temperatur zwischen ca. 450 und 1200°C aufgeheizt wird, so daß sich eine Mischung von Sauerstoff und Kohlenwasserstoffgasen am Substrat selbsttätig entzünden kann,
(d) die oxidationsverhindernde Atmosphäre durch Einleiten der genannten Mischung von Sauerstoff und Kohlenwasserstoffgasen in die Detonationsbrennkammer gegen ein brennbares, kohlenstoffhaltiges Gasgemisch ausgetauscht wird,
(e) sich dieses brennbare, kohlenstoffhaltige Gasgemisch am erhitzten Substrat entzündet und explosionsartig verbrennt.

4. Verfahren nach Anspruch 3,
dadurch gekennzeichnet,
daß die Verfahrensschritte (d) und (e) für die Dauer des Prozesses mit einer vorgewählten Frequenz in Folge wiederholt werden, wobei die vorgewählte Substrattemperatur für die Dauer des Prozesses im wesentlichen konstant gehalten wird.

5. Verfahren nach einem der Ansprüche 1 oder 2,
dadurch gekennzeichnet,
daß die oxidationsverhindernde Atmosphäre durch einen Volumenstrom eines Wasserstoff-Sauerstoff-Gemischs mit einem unterstöchiometrischen Sauerstoffgehalt gebildet wird,
daß zu Beginn des Prozesses dieses oxidationsverhindernde Gasgemisch am Ausgang der Brennkammer gezündet wird, wobei die Strömungsgeschwindigkeit des Volumenstroms so gewählt wird, daß die Flamme in die Brennkammer zurückschlägt,
und daß daraufhin der Volumenstrom der Wasserstoff-Sauerstoff-Mischung erhöht wird, so daß eine Wasserstoff-Sauerstoff-Hochgeschwindigkeitsflamme entsteht, die das Substrat, für den Verfahrensschritt (c) auf die vorgewählte Temperatur erhitzt.

6. Verfahren nach einem der Ansprüche 3 oder 4, wobei die oxidationsverhindernde Atmosphäre durch einen Volumenstrom eines Wasserstoff-Sauerstoff-Gemischs mit einem unterstöchiometrischen Sauerstoffgehalt gebildet wird.

7. Verfahren zur Herstellung von polykristallinen Diamantschichten, bei dem aus einem kohlenstoffhaltigen Gasgemisch Kohlenstoff auf ein, auf eine vorgewählte Temperatur aufgeheiztes, Substrat abgeschieden wird,
dadurch gekennzeichnet,
daß
(a) ein Substrat in einem bestimmten Abstand vor der Mündung eines Hochgeschwindigkeitsbrennersystems oder einer Detonationskanone, welche eine Intervalldetonationsflamme liefert, relativ beweglich befestigt wird,
(b) das Substrat in einer Atmosphäre von oxidationsverhindernden Gasen auf eine Temperatur zwischen 450 und 1200°C aufgeheizt wird,
(d) das Hochgeschwindigkeitsbrennersystem oder die Detonationskanone mit einer Mischung von Sauerstoff und Kohlenwasserstoffgasen beschickt werden,
(d) die Flamme des Hochgeschwindigkeitsbrennersystems bzw. die Intervalldetonationsflamme der Detonationskanone gezündet wird und
(e) die dabei entstehende Hochgeschwindigkeitsflamme oder Intervalldetonationsflamme auf das Substrat gerichtet wird,
wobei das Substrat während der Dauer des Prozesses im wesentlichen konstant auf der vorgewählten Temperatur gehalten wird.

8. Verfahren nach Anspruch 7,
dadurch gekennzeichnet,
daß das Substrat zumindest während des Prozeßschritts (e) gedreht wird, so daß die Flamme die gesamte Oberfläche des Substrats überstreicht.

9. Verfahren nach mindestens einem der vorhergehenden Ansprüche,
dadurch gekennzeichnet,
daß als Kohlenwasserstoffgase des Detonationsgemischs
Acetylen - C₂H₂,
1,3-Butadien 2,5 - C₄H₆,
Butan 2,5 (N-Butan) - C₄H₁₀,
i-Buten 2,3 - C₄H₈,
cis-2-Buten - C₄H₈,
trans-2-Buten - C₄H₈,
1,1-Difluorethan - C₂H₄F₂,
Dimethylamin - C₂H₇N,
2,2-Dimethylpropan - C₅H₁₂,
Ethan - C₂H₆,
Ethen - C₂H₄,
Isobutan - C₄H₁₀,
Isobuten - C₄H₈,
Methan - CH₄,
Methylvinylether - CH₃-O-CH = CH₂
Propan - C₃H₈ und/oder
Propen - C₃H₆
verwendet werden.

10. Verfahren nach mindestens einem der vorhergehenden Ansprüche,
dadurch gekennzeichnet,
daß für die eine Oxidation des Substrat verhindernde Atmosphäre als Schutzgase
Argon - Ar ,
Helium - He ,
Helium-3 He ,
Hexafluorethan - C₂F₆,
Kohlendioxid - CO₂,
Krypton - Kr ,
Neon - Ne und/oder
Xenon - Xe
verwendet werden.

11. Verfahren nach mindestens einem der vorhergehenden Ansprüche,
dadurch gekennzeichnet,
daß das Erhitzen des Substrats durch elektrische Widerstandserwärmung oder durch Induktionserwärmung durchgeführt wird.

12. Verfahren nach mindestens einem der vorhergehenden Ansprüche,
dadurch gekennzeichnet,
daß dem Gemisch von Sauerstoff und Kohlenwasserstoffgasen Kohlendioxid und/oder feinpulverisierter Graphit hinzugefügt wird.

## Patentansprüche (Patentansprüche für folgende(n) Vertragsstaat(en): DE, FR, GB)

1. Verfahren zur Herstellung von polykristallinen Diamantschichten, bei dem aus einem kohlenstoffhaltigen Gasgemisch Kohlenstoff auf ein auf eine vorgewählte Temperatur aufgeheiztes Substrat abgeschieden wird,
dadurch gekennzeichnet,
daß
(a) das Substrat im Inneren einer kühlbaren Brennkammer eines Hochgeschwindigkeitsbrennersystems angebracht wird,
(b) in der Brennkammer durch Einleiten von oxidationsverhindernden Gasen eine Atmosphäre hergestellt wird, die die Oxidation des Substrats verhindert,
(c) das Substrat in dieser oxidationsverhindernden Atmosphäre auf eine vorgewählte Temperatur zwischen ca. 450 und 1200 °C aufgeheizt wird, so daß Sich eine Mischung von Sauerstoff und Kohlenwasserstoffgasen am Substrat selbsttätig entzünden kann,
(d) die oxidationsverhindernde Atmosphäre durch Einleiten der genannten Mischung von Sauerstoff und Kohlenwasserstoffgasen in die Brennkammer gegen ein brennbares, kohlenstoffhaltiges Gasgemisch ausgetauscht wird,
(e) das brennbare, kohlenstoffhaltige Gasgemisch gezündet wird,
wobei die vorgewählte Substrattemperatur während des Prozesses im wesentlichen konstant gehalten wird.

2. Verfahren zur Herstellung von polykristallinen Diamantschichten, bei dem aus einem kohlenstoffhaltigen Gasgemisch Kohlenstoff auf ein, auf eine vorgewählte Temperatur aufgeheiztes, Substrat abgeschieden wird,
dadurch gekennzeichnet,
daß
(a) das Substrat im Inneren einer kühlbaren Brennkammer eines Hochgeschwindigkeitsbrennersystems angebracht wird,
(b) in der Brennkammer durch Einleiten von oxidationsverhindernden Gasen eine Atmosphäre hergestellt wird, die die Oxidation des Substrats verhindert,
(c) das Substrat in dieser oxidationsverhindernden Atmosphäre auf eine vorgewählte Temperatur zwischen ca. 450 und 1200°C aufgeheizt wird, so daß sich eine Mischung von Sauerstoff und Kohlenwasserstoffgasen am Substrat selbsttätig entzünden kann,
(d) die oxidationsverhindernde Atmosphäre durch einleiten der genannten Mischung von Sauerstoff und Kohlenwasserstoffgasen in die Brennkammer gegen ein brennbares, kohlenstoffhaltiges Gasgemisch ausgetauscht wird,
(e) sich das brennbare, kohlenstoffhaltige Gasgemisch selbsttätig am Substrat entzündet,
(f) durch Einleiten von oxidationsverhindernden Gasen wiederum eine Atmosphäre hergestellt wird, die die Oxidation des Substrats verhindert,
(g) die Verfahrensschritte (d) bis (f) für die Dauer des Prozesses mit einer vorgewählten Frequenz in Folge wiederholt werden,
wobei die vorgewählte Substrattemperatur für die Dauer des Prozesses im wesentlichen konstant gehalten wird.

3. Verfahren zur Herstellung von polykristallinen Diamantschichten, bei dem aus einem kohlenstoffhaltigen Gasgemisch Kohlenstoff auf ein, auf eine vorgewählte Temperatur aufgeheiztes, Substrat abgeschieden wird,
dadurch gekennzeichnet,
daß
(a) das Substrat im Inneren einer kühlbaren Detonationsbrennkammer einer Detonationskanone angebracht wird,
(b) in der Detonationsbrennkammer durch Einleiten von oxidationsverhindernden Gasen eine Atmosphäre hergestellt wird, die die Oxidation des Substrats verhindert,
(c) das Substrat in dieser oxidationsverhindernden Atmosphäre auf eine vorgewählte Temperatur zwischen ca. 450 und 1200°C aufgeheizt wird, so daß sich eine Mischung von Sauerstoff und Kohlenwasserstoffgasen am Substrat selbsttätig entzünden kann,
(d) die oxidationsverhindernde Atmosphäre durch Einleiten der genannten Mischung von Sauerstoff und Kohlenwasserstoffgasen in die Detonationsbrennkammer gegen ein brennbares, kohlenstoffhaltiges Gasgemisch ausgetauscht wird,
(e) sich dieses brennbare, kohlenstoffhaltige Gasgemisch am erhitzten Substrat entzündet und explosionsartig verbrennt.

4. Verfahren nach Anspruch 3,
dadurch gekennzeichnet,
daß die Verfahrensschritte (d) und (e) für die Dauer des Prozesses mit einer vorgewählten Frequenz in Folge wiederholt werden, wobei die vorgewählte Substrattemperatur für die Dauer des Prozesses im wesentlichen konstant gehalten wird.

5. Verfahren nach einem der Ansprüche 1 oder 2,
dadurch gekennzeichnet,
daß die oxidationsverhindernde Atmosphäre durch einen Volumenstrom eines Wasserstoff-Sauerstoff-Gemischs mit einem unterstöchiometrischen Sauerstoffgehalt gebildet wird,
daß zu Beginn des Prozesses dieses oxidationsverhindernde Gasgemisch am Ausgang der Brennkammer gezündet wird, wobei die Strömungsgeschwindigkeit des Volumenstroms so gewählt wird, daß die Flamme in die Brennkammer zurückschlägt,
und daß daraufhin der Volumenstrom der Wasserstoff-Sauerstoff-Mischung erhöht wird, so daß eine Wasserstoff-Sauerstoff-Hochgeschwindigkeitsflamme entsteht, die das Substrat, für den Verfahrensschritt (c) auf die vorgewählte Temperatur erhitzt.

6. Verfahren nach einem der Ansprüche 3 oder 4, wobei die oxidationsverhindernde Atmosphäre durch einen Volumenstrom eines Wasserstoff-Sauerstoff-Gemischs mit einem unterstöchiometrischen Sauerstoffgehalt gebildet wird.

7. Verfahren zur Herstellung von polykristallinen Diamantschichten, bei dem aus einem kohlenstoffhaltigen Gasgemisch Kohlenstoff auf ein, auf eine vorgewählte Temperatur aufgeheiztes, Substrat abgeschieden wird,
dadurch gekennzeichnet,
daß
(a) ein Substrat in einem bestimmten Abstand vor der Mündung einer Detonationskanone, welche eine Invervalldetionationsflamme liefert, relativ beweglich befestigt wird,
(b) das Substrat in einer Atmosphäre von oxidationsverhindernden Gasen auf eine Temperatur zwischen 450 und 1200°C aufgeheizt wird,
(c) die Detonationskanone mit einer Mischung von Sauerstoff und Kohlenwasserstoffgasen beschickt wird,
(d) die Intervalldetonationsflamme der Detonationskanone gezündet wird und
(e) die dabei entstehende Intervalldetonationsflamme auf das Substrat gerichtet wird,
wobei das Substrat während der Dauer des Prozesses im wesentlichen konstant auf der vorgewählten Temperatur gehalten wird.

8. Verfahren nach Anspruch 7,
dadurch gekennzeichnet,
daß das Substrat zumindest während des Prozeßschritts (e) gedreht wird, so daß die Flamme die gesamte Oberfläche des Substrats überstreicht.

9. Verfahren nach mindestens einem der vorhergehenden Ansprüche,
dadurch gekennzeichnet,
daß als Kohlenwasserstoffgase des Detonationsgemischs
Acetylen - C₂H₂,
1,3-Butadien 2,5 - C₄H₆,
Butan 2,5 (N-Butan) - C₄H₁₀,
i-Buten 2,3 - C₄H₈,
cis-2-Buten - C₄H₈,
trans-2-Buten - C₄H₈,
1,1-Difluorethan - C₂H₄F₂,
Dimethylamin - C₂H₇N,
2,2-Dimethylpropan - C₅H₁₂,
Ethan - C₂H₆,
Ethen - C₂H₄,
Isobutan - C₄H₁₀,
Isobuten - C₄H₈,
Methan - CH₄,
Methylvinylether - CH₃-O-CH = CH₂
Propan - C₃H₈ und/oder
Propen - C₃H₆
verwendet werden.

10. Verfahren nach mindestens einem der vorhergehenden Ansprüche,
dadurch gekennzeichnet,
daß für die eine Oxidation des Substrat verhindernde Atmosphäre als Schutzgase
Argon - Ar ,
Helium - He ,
Helium-3 He ,
Hexafluorethan - C₂F₆,
Kohlendioxid - CO₂,
Krypton - Kr ,
Neon - Ne und/oder
Xenon - Xe
verwendet werden.

11. Verfahren nach mindestens einem der vorhergehenden Ansprüche,
dadurch gekennzeichnet,
daß das Erhitzen des Substrats durch elektrische Widerstandserwärmung oder durch Induktionserwärmung durchgeführt wird.

12. Verfahren nach mindestens einem der vorhergehenden Ansprüche,
dadurch gekennzeichnet,
daß dem Gemisch von Sauerstoff und Kohlenwasserstoffgasen Kohlendioxid und/oder feinpulverisierter Graphit hinzugefügt wird.

## Claims (Claims for the following Contracting State(s): AT, BE, CH, DK, ES, GR, IT, LI, LU, MC, NL, PT, SE)

1. Method for manufacturing polycrystalline diamond coatings, in which carbon is precipitated out of a carbon-containing gas mixture onto a substrate heated to a pre-selected temperature,
characterized in that
(a) the substrate is placed inside a coolable combustion chamber of a high-speed burner system,
(b) an atmosphere is produced in the combustion chamber by the introduction of oxidation-preventing gases that prevents the oxidation of the substrate,
c) the substrate is heated in this oxidation-preventing atmosphere to a pre-selected temperature of between approx. 450 and 1200° C, so that a mixture of oxygen and hydrocarbon gases can ignite spontaneously on the substrate,
(d) the oxidation-preventing atmosphere is replaced by a combustible, carbon-containing gas mixture by the introduction of the above-mentioned mixture of oxygen and hydrocarbon gases into the combustion chamber,
(e) the combustible, carbon-containing gas mixture is ignited,
wherein the pre-selected substrate temperature is kept essentially constant during the process.

2. Method for manufacturing polycrystalline diamond coatings, in which carbon is precipitated out of a carbon-containing gas mixture onto a substrate heated to a pre-selected temperature,
characterised in that
(a) the substrate is placed inside a coolable combustion chamber of a high-speed burner system,
(b) an atmosphere is produced in the combustion chamber by the introduction of oxidation-preventing gases that prevents the oxidation of the substrate,
c) the substrate is heated in this oxidation-preventing atmosphere to a pre-selected temperature of between approx. 450 and 1200° C, so that a mixture of oxygen and hydrocarbon gases can ignite spontaneously on the substrate,
(d) the oxidation-preventing atmosphere is replaced by a combustible, carbon-containing gas mixture by the introduction of the above-mentioned mixture of oxygen and hydrocarbon gases into the combustion chamber,
(e) the combustible, carbon-containing gas mixture ignites spontaneously on the substrate,
(f) by the introduction of oxidation-preventing gases an atmosphere is again produced that prevents the oxidation of the substrate,
(g) the method steps (d) to (f) are repeated in sequence with a pre-selected frequency for the duration of the process,
wherein the pre-selected substrate temperature is kept essentially constant for the duration of the process.

3. Method for manufacturing polycrystalline diamond coatings, in which carbon is precipitated out of a carbon-containing gas mixture onto a substrate heated to a pre-selected temperature,
characterised in that
(a) the substrate is placed inside a coolable detonation combustion chamber of a detonation gun,
(b) an atmosphere is produced in the detonation combustion chamber by the introduction of oxidation-preventing gases that prevents the oxidation of the substrate,
c) the substrate is heated in this oxidation-preventing atmosphere to a pre-selected temperature of between approx. 450 and 1200° C, so that a mixture of oxygen and hydrocarbon gases can ignite spontaneously on the substrate,
(d) the oxidation-preventing atmosphere is replaced by a combustible, carbon-containing gas mixture by the introduction of the above-mentioned mixture of oxygen and hydrocarbon gases into the detonation combustion chamber,
(e) said combustible, carbon-containing gas mixture ignites on the heated substrate and burns after the manner of an explosion.

4. Method according to claim 3,
characterised in that
the method steps (d) and (e) are repeated in sequence with a pre-selected frequency for the duration of the process, wherein the pre-selected substrate temperature is kept essentially constant for the duration of the process.

5. Method according to either of claims 1 or 2,
characterised in that
the oxidation-preventing atmosphere is formed by a volume flow of a hydrogen-oxygen mixture with a sub-stoichiometric oxygen content,
that at the start of the process said oxidation-preventing gas mixture is ignited at the outlet of the combustion chamber, wherein the flow velocity of the volume flow is selected so that the flame strikes back into the combustion chamber,
and that the volume flow of the hydrogen-oxygen mixture is then increased so that a high-speed hydrogen-oxygen flame is obtained, which heats the substrate to the pre-selected temperature for the method step (c).

6. Method according to either of claims 3 or 4, wherein the oxidation-preventing atmosphere is formed by a volume flow of a hydrogen-oxygen mixture with a sub-stoichiometric oxygen content.

7. Method for manufacturing polycrystalline diamond coatings, in which carbon is precipitated out of a carbon-containing gas mixture onto a substrate heated to a pre-selected temperature,
characterised in that
(a) a substrate is secured so as to be relatively mobile at a particular distance in front of the mouth of a high-speed burner system or of a detonation gun that supplies an interval detonation flame,
(b) the substrate is heated up in an atmosphere of oxidation-preventing gases to a temperature of between 450 and 1200° C,
(c) the high-speed burner system or the detonation gun is loaded with a mixture of oxygen and hydrocarbon gases,
(d) the flame of the high-speed burner system or the interval detonation flame of the detonation gun is ignited and
(e) the high-speed flame or interval detonation flame thereby produced is directed onto the substrate,
wherein the substrate is held essentially constantly at the pre-selected temperature for the duration of the process.

8. Method according to claim 7,
characterised in that
the substrate is rotated at least during process step (e), so that the flame extends over the whole surface of the substrate.

9. Method according to at least one of the preceding claims,
characterised in that
there are used as hydrocarbon gases of the detonation mixture:
acetylene - C₂H₂,
1,3-butadiene 2,5 - C₄H₆,
butane 2,5 (N-butane) - C₄H₁₀,
i-butene 2,3 - C₄H₈,
cis-2-butene - C₄H₈,
trans-2-butene - C₄H₈,
1,1-difluoroethane - C₂H₄F₂,
dimethylamine - C₂H₇N,
2,2-dimethylpropane - C₅H₁₂,
ethane - C₂H₆,
ethene - C₂H₄,
isobutane - C₄H₁₀,
isobutene - C₄H₈,
methane - CH₄,
methylvinyl ether - CH₃-O-CH = CH₂,
propane - C₃H₈ and/or
propene - C₃H₈.

10. Method according to at least one of the preceding claims,
characterised in that
there are used as protective gases for the atmosphere preventing an oxidation of the substrate:
argon - Ar,
helium - He,
helium-3 He,
hexafluoroethane - C₂F₆,
carbon dioxide - CO₂,
krypton - Kr,
neon - Ne and/or
xenon - Xe.

11. Method according to at least one of the preceding claims,
characterised in that
the heating of the substrate is carried out by electric resistance heating or by induction heating.

12. Method according to at least one of the preceding claims,
characterised in that
carbon dioxide and/or finely powdered graphite are added to the mixture of oxygen and hydrocarbon gases.

## Claims (Claims for the following Contracting State(s): DE, FR, GB)

1. Method for manufacturing polycrystalline diamond coatings, in which carbon is precipitated out of a carbon-containing gas mixture onto a substrate heated to a pre-selected temperature,
characterised in that
(a) the substrate is placed inside a coolable combustion chamber of a high-speed burner system,
(b) an atmosphere is produced in the combustion chamber by the introduction of oxidation-preventing gases that prevents the oxidation of the substrate,
c) the substrate is heated in this oxidation-preventing atmosphere to a pre-selected temperature of between approx. 450 and 1200° C, so that a mixture of oxygen and hydrocarbon gases can ignite spontaneously on the substrate,
(d) the oxidation-preventing atmosphere is replaced by a combustible, carbon-containing gas mixture by the introduction of the above-mentioned mixture of oxygen and hydrocarbon gases into the combustion chamber,
(e) the combustible, carbon-containing gas mixture is ignited,
wherein the pre-selected substrate temperature is kept essentially constant during the process.

2. Method for manufacturing polycrystalline diamond coatings, in which carbon is precipitated out of a carbon-containing gas mixture onto a substrate heated to a pre-selected temperature,
characterised in that
(a) the substrate is placed inside a coolable combustion chamber of a high-speed burner system,
(b) an atmosphere is produced in the combustion chamber by the introduction of oxidation-preventing gases that prevents the oxidation of the substrate,
c) the substrate is heated in this oxidation-preventing atmosphere to a pre-selected temperature of between approx. 450 and 1200° C, so that a mixture of oxygen and hydrocarbon gases can ignite spontaneously on the substrate,
(d) the oxidation-preventing atmosphere is replaced by a combustible, carbon-containing gas mixture by the introduction of the above-mentioned mixture of oxygen and hydrocarbon gases into the combustion chamber,
(e) the combustible, carbon-containing gas mixture ignites spontaneously on the substrate,
(f) by the introduction of oxidation-preventing gases an atmosphere is again produced that prevents the oxidation of the substrate,
(g) the method steps (d) to (f) are repeated in sequence with a pre-selected frequency for the duration of the process,
wherein the pre-selected substrate temperature is kept essentially constant for the duration of the process.

3. Method for manufacturing polycrystalline diamond coatings, in which carbon is precipitated out of a carbon-containing gas mixture onto a substrate heated to a pre-selected temperature,
characterised in that
(a) the substrate is placed inside a coolable detonation combustion chamber of a detonation gun,
(b) an atmosphere is produced in the detonation combustion chamber by the introduction of oxidation-preventing gases that prevents the oxidation of the substrate,
c) the substrate is heated in this oxidation-preventing atmosphere to a pre-selected temperature of between approx. 450 and 1200° C, so that a mixture of oxygen and hydrocarbon gases can ignite spontaneously on the substrate,
(d) the oxidation-preventing atmosphere is replaced by a combustible, carbon-containing gas mixture by the introduction of the above-mentioned mixture of oxygen and hydrocarbon gases into the detonation combustion chamber,
(e) said combustible, carbon-containing gas mixture ignites on the heated substrate and burns after the manner of an explosion.

4. Method according to claim 3,
characterised in that
the method steps (d) and (e) are repeated in sequence with a pre-selected frequency for the duration of the process, wherein the pre-selected substrate temperature is kept essentially constant for the duration of the process.

5. Method according to either of claims 1 or 2,
characterised in that
the oxidation-preventing atmosphere is formed by a volume flow of a hydrogen-oxygen mixture with a sub-stoichiometric oxygen content,
that at the start of the process said oxidation-preventing gas mixture is ignited at the outlet of the combustion chamber, wherein the flow velocity of the volume flow is selected so that the flame strikes back into the combustion chamber,
and that the volume flow of the hydrogen-oxygen mixture is then increased so that a high-speed hydrogen-oxygen flame is obtained, which heats the substrate to the pre-selected temperature for the method step (c).

6. Method according to either of claims 3 or 4, wherein the oxidation-preventing atmosphere is formed by a volume flow of a hydrogen-oxygen mixture with a sub-stoichiometric oxygen content.

7. Method for manufacturing polycrystalline diamond coatings, in which carbon is precipitated out of a carbon-containing gas mixture onto a substrate heated to a pre-selected temperature,
characterised in that
(a) a substrate is secured so as to be relatively mobile at a particular distance in front of the mouth of a detonation gun that supplies an interval detonation flame,
(b) the substrate is heated up in an atmosphere of oxidation-preventing gases to a temperature of between 450 and 1200° C,
(c) the detonation gun is loaded with a mixture of oxygen and hydrocarbon gases,
(d) the interval detonation flame of the detonation gun is ignited and
(e) the interval detonation flame thereby produced is directed onto the substrate,
wherein the substrate is held essentially constantly at the pre-selected temperature for the duration of the process.

8. Method according to claim 7,
characterised in that
the substrate is rotated at least during process step (e), so that the flame extends over the whole surface of the substrate.

9. Method according to at least one of the preceding claims,
characterised in that
there are used as hydrocarbon gases of the detonation mixture:
acetylene - C₂H₂,
1,3-butadiene 2,5 - C₄H₆,
butane 2,5 (N-butane) - C₄H₁₀,
i-butene 2,3 - C₄H₈,
cis-2-butene - C₄H₈,
trans-2-butene - C₄H₈,
1,1-difluoroethane - C₂H₄F₂,
dimethylamine - C₂H₇N,
2,2-dimethylpropane - C₅H₁₂,
ethane - C₂H₆,
ethene - C₂H₄,
isobutane - C₄H₁₀,
isobutene - C₄H₈,
methane - CH₄,
methylvinyl ether - CH₃-O-CH = CH₂,
propane - C₃H₈ and/or
propene - C₃H₈.

10. Method according to at least one of the preceding claims,
characterised in that
there are used as protective gases for the atmosphere preventing an oxidation of the substrate:
argon - Ar,
helium - He,
helium-3 He,
hexafluoroethane - C₂F₆,
carbon dioxide - CO₂,
krypton - Kr,
neon - Ne and/or
xenon - Xe.

11. Method according to at least one of the preceding claims,
characterised in that
the heating of the substrate is carried out by electric resistance heating or by induction heating.

12. Method according to at least one of the preceding claims,
characterised in that
carbon dioxide and/or finely powdered graphite are added to the mixture of oxygen and hydrocarbon gases.

## Revendications (Revendications pour l'(les) Etat(s) contractant(s) suivant(s): AT, BE, CH, DK, ES, GR, IT, LI, LU, MC, NL, PT, SE)

1. Procédé de fabrication de couches polycristallines de diamant, dans lequel, à partir d'un mélange gazeux carboné, on dépose du carbone sur un substrat chauffé à une température préalablement choisie, caractérisé en ce que :
(a) le substrat est mis en place à l'intérieur d'une chambre de combustion, pouvant être refroidie, d'un système de brûleur à grande vitesse,
(b) on crée, dans la chambre de combustion, par introduction de gaz empêchant l'oxydation, une atmosphère qui empêche l'oxydation du substrat,
(c) on chauffe le substrat, dans cette atmosphère empêchant l'oxydation, à une température préalablement choisie, comprise entre environ 450 et 1 200°C, de sorte qu'un mélange d'oxygène et d'hydrocarbures gazeux peut s'enflammer automatiquement sur le substrat,
(d) on remplace l'atmosphère empêchant l'oxydation par un mélange gazeux carboné combustible, par introduction dudit mélange d'oxygène et d'hydrocarbures gazeux dans la chambre de combustion, et
(e) on enflamme le mélange gazeux carboné combustible,
la température préalablement choisie du substrat étant maintenue essentiellement constante pendant le procédé.

2. Procédé de fabrication de couches polycristallines de diamant, dans lequel, à partir d'un mélange gazeux carboné, on dépose du carbone sur un substrat chauffé à une température préalablement choisie, caractérisé en ce que :
(a) le substrat est mis en place à l'intérieur d'une chambre de combustion, pouvant être refroidie, d'un système de brûleur à grande vitesse,
(b) on crée, dans la chambre de combustion, par introduction de gaz empêchant l'oxydation, une atmosphère qui empêche l'oxydation du substrat,
(c) on chauffe le substrat, dans cette atmosphère empêchant l'oxydation, à une température préalablement choisie, comprise entre environ 450 et 1 200°C, de sorte qu'un mélange d'oxygène et d'hydrocarbures gazeux peut s'enflammer automatiquement sur le substrat,
(d) on remplace l'atmosphère empêchant l'oxydation par un mélange gazeux carboné combustible, par introduction dudit mélange d'oxygène et d'hydrocarbures gazeux dans la chambre de combustion,
(e) le mélange gazeux carboné combustible s'enflamme automatiquement,
(f) grâce à l'introduction de gaz empêchant l'oxydation, on crée de nouveau une atmosphère qui empêche l'oxydation du substrat,
(g) on recommence les étapes de procédé (d) à (f), dans cet ordre, pendant la durée du procédé, avec une fréquence préalablement choisie,
la température préalablement choisie du substrat étant maintenue essentiellement constante pendant la durée du procédé.

3. Procédé de fabrication de couches polycristallines de diamant, dans lequel, à partir d'un mélange gazeux carboné, on dépose du carbone sur un substrat chauffé à une température préalablement choisie, caractérisé en ce que :
(a) le substrat est mis en place à l'intérieur d'une chambre de combustion à détonation, pouvant être refroidie, d'un canon à détonation,
(b) on crée, dans la chambre de combustion à détonation, par introduction de gaz empêchant l oxydation, une atmosphère qui empêche l'oxydation du substrat,
(c) on chauffe le substrat, dans cette atmosphère empêchant l'oxydation, à une température préalablement choisie, comprise entre environ 450 et 1 200°C, de sorte qu'un mélange d'oxygène et d'hydrocarbures gazaux peut s'enflammer automatiquement sur le substrat,
(d) on remplace l'atmosphère empêchant l'oxydation par un mélange gazeux carboné combustible, par introduction dudit mélange d'oxygène et d'hydrocarbures gazeux dans la chambre de combustion par détonation, et
(e) ce mélange gazeux carboné combustible s'enflamme sur le
substrat chauffé et brûle sous forme d'explosion.

4. Procédé selon la revendication 3, caractérisé en ce qu'on recommence les étapes de procédé (d) et (e), dans cet ordre, avec une fréquence préalablement choisie, pendant la durée du procédé, la température préalablement choisie du substrat étant maintenue essentiellement constante pendant la durée du procédé.

5. Procédé selon la revendication 1 ou 2, caractérisé en ce que l'atmosphère empêchant l'oxydation est formée par un flux volumique d'un mélange d'hydrogène et d'oxygène dont la teneur en oxygène est inférieure à la quantité stoechiométrique,
en ce qu'au début du procédé, ce mélange gazeux empêchant l'oxydation est enflammé à la sortie de la chambre de combustion, la vitesse d'écoulement du flux volumique étant choisie d'une manière telle qu'il y a un retour de flamme dans la chambre de combustion,
et en ce que, ensuite, le flux volumique du mélange d'hydrogène et d'oxygène est augmenté, de sorte qu'une flamme oxhydrique à grande vitesse est formée, qui chauffe le substrat à là température préalablement choisie pour l'étape (c) du procédé.

6. Procédé selon la revendication 3 ou 4, dans lequel l'atmosphère empêchant l'oxydation est formée par un flux volumique d'un mélange d'hydrogène et d'oxygène avec une teneur en oxygène qui est inférieure à la quantité stoechiométrique.

7. Procédé de fabrication de couches polycristallines de diamant, dans lequel, à partir d'un mélange gazeux carboné, on dépose du carbone sur un substrat chauffé à une température préalablement choisie, caractérisé en ce que :
(a) un substrat est fixé d'une manière relativement mobile, à une distance définie à l'avant de l'embouchure d'un système de brûleur à grande vitesse ou d'un canon à détonation qui délivre par intermittence une flamme de détonation,
(b) on chauffe le substrat, dans une atmosphère de gaz empêchant l'oxydation, à une température comprise entre 450 et 1 200°C,
(c) on introduit un mélange d'oxygène et d'hydrocarbures gazeux dans le système de brûleur à grande vitesse ou dans le canon à détonation,
(d) on allume la flamme du système de brûleur à grande vitesse ou la flamme intermittente de détonation du canon à détonation, et
(e) la flamme à grande vitesse ou la flamme intermittente de détonation ainsi formée est dirigée dans la direction du substrat,
la température préalablement choisie du substrat étant maintenue essentiellement constante pendant la durée du procédé.

8. Procédé selon la revendication 7, caractérisé en ce que le substrat est mis en rotation, au moins pendant l'étape (e) du procédé, de manière que la flamme balaie toute la surface du substrat.

9. Procédé selon au moins l'une des revendications précédentes, caractérisé en ce qu'on utilise, comme hydrocarbures gazeux du mélange de détonation :
l'acétylène - C₂H₂,
le 1,3 butadiène 2,5 - C₄H₆,
le butane 2,5 (N butane) C₄H₁₀,
l'i-butène 2,3 - C₄H₈,
le cis-2-butène - C₄H₈,
le trans-2-butène - C₄H₈,
le 1,1-difluoroéthane - C₂H₄F₂,
la diméthylamine - C₂H₇N,
la 2,2 diméthylpropane - C₅H₁₂,
l'éthane - C₂H₆,
l'éthène - C₂H₄,
l'isobutane - C₄H₁₀,
l'isobutène - C₄H₈,
le méthane - CH₄,
l'éther méthylvinylique - CH₃-O-CH=CH₂
le propane - C₃H₈, et/ou
le propène - C₃H₆.

10. Procédé selon au moins l'une des revendications précédentes, caractérisé en ce qu'on utilise, comme gaz protecteurs pour l'atmosphère empêchant l'oxydation du substrat :
l'argon - Ar,
l'hélium - He,
l'hélium-3 He,
l'hexafluoroéthane - C₂F₆,
le dioxyde de carbone CO₂,
le krypton - Kr,
le néon - Ne, et/ou
la xénon - Xe.

11. Procédé selon au moins l'une des revendications précédentes, caractérise en ce qu'on effectue le chauffage du substrat au moyen d'un chauffage par résistance électrique ou au moyen d'un chauffage par induction.

12. Procédé selon au moins l'une des revendications précédentes, caractérisé en ce qu'on ajoute du dioxyde de carbone et/ou du graphite finement pulvérisé au mélange d'oxygène et d'hydrocarbures gazeux.

## Revendications (Revendications pour l'(les) Etat(s) contractant(s) suivant(s): DE, FR, GB)

1. Procéde de fabrication de couches polycristallines de diamant, dans lequel, à partir d'un mélange gazeux carboné, on dépose du carbone sur un substrat chauffé à une température préalablement choisie, caractérisé en ce que :
(a) le substrat est mis en place à l'intérieur d'une chambre de combustion, pouvant être refroidie, d'un système du brûleur à grande vitesse,
(b) on crée, dans la chambre de combustion, par introduction de gaz empêchant l'oxydation, une atmosphère qui empêche l'oxydation du substrat,
(c) on chauffe le substrat, dans cette atmosphère empêchant l'oxydation, à une température préalablement choisie, comprise entre environ 450 et 1 200°C, de sorte qu'un mélange d'oxygène et d'hydrocarbures gazeux peut s'enflammer automatiquement sur le substrat,
(d) on remplace l'atmosphère empêchant l'oxydation par un mélange gazeux carboné combustible, par introduction dudit mélange d'oxygène et d'hydrocarbures gazeux dans la chambre de combustion, et
(e) on enflamme le mélange gazeux carboné combustible,
la température préalablement choisie du substrat étant maintenue essentiellement constante pendant le procédé.

2. Procédé de fabrication de couches polycristallines de diamant, dans lequel, à partir d'un mélange gazeux carboné, on dépose du carbone sur un substrat chauffé à une température préalablement choisie, caractérisé en ce que :
(a) le substrat est mis en place à l'intérieur d'une chambre de combustion, pouvant être refroidie, d'un système de brûleur à grande vitesse,
(b) on crée, dans la chambre de combustion, par introduction de gaz empêchant l'oxydation, une atmosphère qui empêche l'oxydation du substrat,
(c) on chauffe le substrat, dans cette atmosphère empêchant l'oxydation, à une température préalablement choisie, comprise entre environ 450 et 1 200°C, de sorte qu'un mélange d'oxygène et d'hydrocarbures gazeux peut s'enflammer automatiquement sur le substrat,
(d) on remplace l'atmosphère empêchant l'oxydation par un mélange gazeux carboné combustible, Par introduction dudit mélange d'oxygène et d'hydrocarbures gazeux dans la chambre de combustion,
(e) le mélange gazeux carboné combustible s'enflamme automatiquement,
(f) grâce à l'introduction de gaz empêchant l'oxydation, on crée de nouveau une atmosphère qui empêche l'oxydation du substrat,
(g) on recommence les étapes de procédé (d) à (f), dans cet ordre, pendant la durée du procédé, avec une fréquence préalablement choisie,
la température préalablement choisie du substrat étant maintenue essentiellement constante pendant la durée du procédé.

3. Procédé de fabrication de couches polycristallines de diamant, dans lequel, à partir d'un mélange gazeux carboné, on dépose du carbone sur un substrat chauffé à une température préalablement choisie, caractérisé en ce que :
(a) le substrat est mis en place à l'intérieur d'une chambre de combustion à détonation, pouvant être refroidie, d'un canon à détonation,
(b) on crée, dans la chambre de combustion à détonation, par introduction de gaz empêchant l'oxydation, une atmosphère qui empêche l'oxydation du substrat,
(c) on chauffe le substrat, dans cette atmosphère empêchant l'oxydation, à une température préalablement choisie, comprise entre environ 450 et 1 200°C, de sorte qu'un mélange d'oxygène et d'hydrocarbures gazeux peut s'enflammer automatiquement sur le substrat,
(d) on remplace l'atmosphère empêchant l'oxydation par un mélange gazeux carboné combustible, par introduction dudit mélange d'oxygène et d'hydrocarbures gazeux dans la chambre de combustion par détonation, et
(e) ce mélange gazeux carboné combustible s'enflamme sur le substrat chauffé et brûle sous forme d'explosion.

4. Procédé selon la revendication 3, caractérisé en ce qu'on recommence les étapes de procédé (d) et (e), dans cet ordre, avec une fréquence préalablement choisie, pendant la durée du procédé, la température préalablement choisie du substrat étant maintenue essentiellement constante pendant la durée du procédé.

5. Procédé selon la revendication 1 ou 2, caractérisé en ce que l'atmosphère empêchant l'oxydation est formée par un flux volumique d'un mélange d'hydrogène et d'oxygène dont la teneur en oxygène est inférieure à la quantité stoechiométrique,
en ce qu'au début du procédé, ce mélange qazeux empêchant l'oxydation est enflammé à la sortie de la chambre de combustion, la vitesse d'écoulement du flux volumique étant choisie d'une manière telle qu'il y a un retour de flamme dans la chambre de combustion,
et en ce que, ensuite, le flux volumique du mélange d'hydrogène et d'oxygène est augmenté, de sorte qu'une flamme oxhydrique à grande vitesse est formée, qui chauffe le substrat à la température préalablement choisie pour l'étape (c) du procédé.

6. Procéde selon la revendication 3 ou 4, dans lequel l'atmosphère empêchant l'oxydation est formée par un flux volumique d'un mélange d'hydrogène et d'oxygène avec une teneur en oxygène qui est inférieure à la quantité stoechiométrique.

7. Procédé de fabrication de couches polycristallines de diamant, dans lequel, à partir d'un mélange gazeux carboné, on dépose de carbone sur un substrat chauffé à une température préalablement choisie, caractérisé en ce que :
(a) un substrat est fixé d'une manière relativement mobile, à une distance définie, à l'avant de l'embouchure d'un canon à détonation qui délivre par intermittence une flamme de détonation,
(b) on chauffe le substrat, dans une atmosphère de gaz empêchant l'oxydation, à une température comprise entre 450 et 1 200°C,
(c) on introduit un mélange d'oxygène et d'hydrocarbures gazeux dans le canon à détonation,
(d) on allume la flamme intermittente de détonation du canon à détonation, et
(e) la flamme intermittente de détonation ainsi formée est dirigée dans la direction du substrat,
la température préalablement choisie du substrat étant maintenue essentiellement constante pendant la durée du procédé.

8. Procédé selon la revendication 7, caractérisé en ce que le substrat est mis en rotation, au moins pendant l'étape (e) du procédé, de manière que la flamme balaie toute la surface du substrat.

9. Procédé selon au moins l'une des revendications précédentes, caractérisé en ce qu'on utilise, comme hydrocarbures gazeux de mélange de détonation :
l'acétylène - C₂H₂,
le 1,3-butadiène 2,5 - C₄H₆,
le butane 2,5 (N butane) - C₄H₁₀,
l'i-butène 2,3 - C₄H₈,
le cis-2-butène - C₄H₈,
le trans 2 butène - C₄H₈,
le 1,1-difluoroéthane - C₂H₄F₂,
la diméthylamine - C₂H₇N,
le 2,2-diméthylpropane - C₅H₁₂,
l'éthane - C₂H₆,
l'éthène - C₂H₄,
l'isobutane - C₄H₁₀,
l'isobutène - C₄H₈,
le méthane - CH₄,
l'éther méthylvinylique - CH₃-O-CH=CH₂
le propane - C₃H₈, et/ou
le propène - C₃H₆.

10. Procédé selon au moins l'une des revendications précédentes, caractérisé en ce qu'on utilise, comme gaz protecteurs pour l'atmosphère empêchant l'oxydation du substrat :
l'argon - Ar,
l'hélium - He,
l'hélium-3 He,
l'hexafluoroéthane - C₂F₆,
le dioxyde de carbone - CO₂,
le krypton - Kr,
le néon - Ne, et/ou
le xénon - Xe.

11. Procédé selon au moins l'une des revendications précédentes, caractérisé en ce qu'on effectue le chauffage du substrat au moyen d'un chauffage par résistance électrique ou au moyen d'un chauffage par induction.

12. Procédé selon au moins l'une des revendications précédentes, caractérisé en ce qu'on ajoute du dioxyde de carbone et/ou du graphite finement pulvérisé au mélange d'oxygène et d'hydrocarbures gazeux.
